**Europäisches Patentamt**

**European Patent Office**

**Office européen des brevets**

(19)

(11) Numéro de publication : **0 480 780 A1**

(12) # DEMANDE DE BREVET EUROPEEN

(21) Numéro de dépôt : **91402304.9**

(22) Date de dépôt : **23.08.91**

(51) Int. Cl.⁵ : **H01L 31/0352, H01L 33/00, H01S 3/19**

(30) Priorité : **31.08.90 FR 9010871**

(43) Date de publication de la demande :
**15.04.92 Bulletin 92/16**

(84) Etats contractants désignés :
**DE GB**

(71) Demandeur : **THOMSON-CSF**
**51, Esplanade du Général de Gaulle**
**F-92800 Puteaux (FR)**

(72) Inventeur : **Razeghi, Manijeh**
**THOMSON-CSF SCPI Cédex 67**
**F-92045 Paris la Défense (FR)**
Inventeur : **Omnes, Franck**
**THOMSON-CSF SCPI Cédex 67**
**F-92045 Paris la Défense (FR)**

(74) Mandataire : **Guérin, Michel et al**
**THOMSON-CSF SCPI**
**F-92045 PARIS LA DEFENSE CEDEX 67 (FR)**

(54) **Dispositif optoélectronique et application à la réalisation d'un laser et d'un photodétecteur.**

(57) Dispositif optoélectronique à semiconducteur dans lequel les couches de confinement (2, 4) sont en GaInP et la couche active (3) comprend au moins un puis quantique (31) $Ga_xIn_{1-x}As$ compris entre deux couches 30 et 40 en GaAs ;

APPLICATIONS : Ce dispositif est applicable à la réalisation de lasers et de photodétecteurs.

Ga As
(N) substrat
N contact (Au)

# FIG.1

EP 0 480 780 A1

L'invention est applicable à un dispositif optoélectronique et son application à un laser et à un photodétecteur à puits quantiques.

Dans le cas d'un laser à puits quantiques elle concerne notamment un type de laser adaptable à l'émission de différentes longueurs d'ondes telles que les longueurs d'ondes 0,98 µm, 1,083 µm, 1,054 µm ou 2,5 µm.

L'invention concerne également un photodétecteur à puits quantiques et notamment un type de photodétecteur adaptable à la détection de différentes longueurs d'ondes.

Un très grand intérêt est actuellement porté sur les amplificateurs optiques utilisant comme élément actif des fibres optiques dopées à l'erbium pompées de manière optique ; il est nécessaire pour réaliser ce pompage optique de disposer de diodes laser émettant à la longueur d'onde de 0,98 µm.

D'autre part, l'atome de l'isotope He$^3$ de l'hélium possède un spin nucléaire et peut être utilisé en magnétométrie à condition d'avoir été préalablement polarisé. Sous l'effet d'un champ magnétique, la fréquence de précession peut être déterminée de façon précise et fournit une mesure absolue du champ magnétique.

La polarisation nécessaire peut être obtenue par pompage optique à la longueur d'onde de 1, 083 µm.

Enfin, l'emploi de chaînes amplificatrices à base de verre phosphate dopé Nd$^{3+}$ nécessite pour leur commande la réalisation d'un oscillateur ou d'un système d'injection qui doit émettre une onde optique centrée sur la longueur d'onde d'émission de l'ion terre rare inséré dans la matrice.

Dans ce cas, la longueur d'onde d'émission est centrée sur 1. 054 µm.

Il est difficile d'élaborer des lasers semiconducteurs émettant à 0. 98, 1. 083 ou 1. 054 µm. Pour cette raison, l'invention consiste à élaborer un laser semiconducteur à base de matériaux GaInP-GaInAs-GaAs émettant à la longueur d'onde de 0. 98, 1. 083 ou 1. 054 µm.

Il est intéressant également de disposer de photodétecteurs capables de détecter la longueur d'onde de 2.5 µm pour les raisons suivantes :

1) Les nouvelles générations de systèmes de télécommunications par fibres optiques mettent en oeuvre des fibres optiques à base de verres fluorés, lesquelles présentent un minimum de pertes pour la longueur d'onde de 2.5 µm.

Il est nécessaire dans ces systèmes d'utiliser des photodétecteurs fonctionnant à cette longueur d'onde.

2) Une fenêtre de transmission atmosphérique existe pour des longueurs d'onde comprises entre 2 et 2.5 µm. Elle peut être exploitée pour l'observation de la Terre par satellite (programme SPOT : Satellite pour l'Observation de la Terre).

Des photodétecteurs fonctionnant à la longueur d'onde de 2.5 µm sont nécessaires pour cette application.

Les matériaux InAs-Sb. P/InAs permettent d'ores et déjà de réaliser des photodétecteurs fonctionnant à la longueur d'onde de 2.5 µm.

L'invention fournit une structure adaptable à la détection de rayonnements de différentes longueurs d'onde telles 2 µm ou 2.5 µm.

L'invention concerne donc un dispositif optoélectronique caractérisé en ce qu'il comporte une couche active contenant au moins un puits quantique constitué d'une couche à base de GaInAs comprise entre deux couches barrières à base de GaAs, cette couche active étant comprise entre une première et une deuxième couche de confinement à base de GaInP

L'invention concerne également un laser à puits quantiques caractérisé en ce qu'il comporte une couche active contenant au moins un puits quantique constitué d'une couche à base de $Ga_xIn_{1-x}As$ comprise entre deux couches de GaAs, cette couche active étant comprise entre une première et une deuxième couches de confinement à base de GaInP.

Selon l'invention, ce laser est réalisé sur un substrat, la composition de la première couche de confinement, qui est en contact avec le substrat, étant telle que son paramètre de maille est adapté à celui du substrat.

De plus, la couche de $Ga_xIn_{1-x}As$ a une composition telle que x est compris entre 0,11 et 0,99 et son épaisseur est comprise entre 9 nm et 5 nm.

L'invention concerne également un photodétecteur, caractérisé en ce qu'il comporte au moins un puits quantique constitué d'une couche à base de $Ga_{1-x}In_xAs$ comprise entre deux couches barrière à base de GaAs, l'ensemble étant compris entre une première et une deuxième couches de confinement à base de GaInP.

Selon l'invention, ce photodétecteur est réalisé sur un substrat dont le paramètre de maille peut être adapté à celui de la première couche de confinement.

De plus, la couche de $Ga_{1-x}In_xAs$ a une composition telle que x est compris entre 0,5 et 0,95 et son épaisseur est comprise entre 5 et 9 nm.

Les différents objets et caractéristiques de l'invention apparaîtront plus clairement dans la description qui va suivre faite à titre d'exemple et dans les figures annexées qui représentent :
– la figure 1, un exemple de réalisation d'un laser selon l'invention ;
– les figures 2 à 5, des diagrammes d'énergie illustrant différentes compositions possible de la couche active du laser ;

– la figure 6, un exemple de réalisation d'un photodétecteur selon l'invention ;

– la figure 7, un diagramme de la bande de conduction du dispositif de la figure 1.

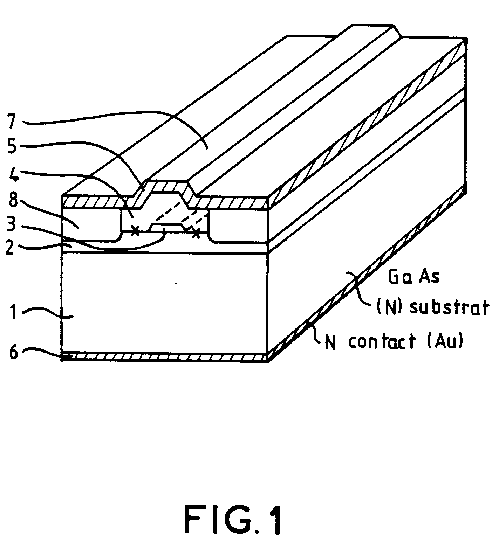

On va donc tout d'abord décrire un exemple de réalisation du dispositif de l'invention en se reportant à la figure 1. Ce dispositif comporte sur un substrat 1, une première couche de confinement réalisée en matériau à base de GaInP présentant un paramètre de maille adapté à celui du substrat 1. Sur cette couche de confinement 2 est réalisé un élément actif 3 se présentant, selon la figure 1, sous la forme d'un ruban. Cet élément actif comporte au moins un puits quantique tel qu'illustré par le diagramme d'énergie de la bande de conduction de la figure .2

Ce puits quantique comporte une couche centrale 31 à base de $Ga_xIn_{1-x}As$ comprise entre deux couches barrières 30 et 40 à base de GaAs. La première couche de confinement 2 et l'élément actif 3 sont recouverts d'une deuxième couche de confinement 4 également à base de GaInP. De part et d'autre de l'élément actif 3, les couches de confinement 2 et 4 ont subi une implantation protonique de façon à réduire les fuites. La partie supérieure de la structure comporte, notamment au dessus la deuxième couche de confinement 4, une couche de contact en GaAs surmonté d'un contact ohmique 7.

Un autre contact ohmique 6 est prévu sur le côté opposé de la structure de façon à connecter une source de courant de commande du dispositif. Selon l'exemple de la figure 1, le contact ohmique 6 est situé sur une face de substrat, le substrat étant alors en matériau conducteur. On pourrait également prévoir, entre la couche de confinement et le substrat, une couche de semiconducteur dopé servant de couche de contact sur laquelle serait prévu un contact ohmique.

Selon l'invention, le dispositif optoélectronique de la figure 1 est un laser à semiconducteur. L'élément actif 3 en forme de ruban est donc un élément actif laser.

A titre d'exemple, le substrat 1 de la figure 1 est en GaAs dopé N. La première couche de confinement 2 en GaInP est dopé N. La deuxième couche de confinement 3 en GaInP est dopé P. La couche de contact 5 est en GaAs dopé P+.

Les contacts ohmiques sont en or par exemple.

Le substrat 1 pourrait également être en InP ou en silicium, on prévoirait alors une couche ou un réseau d'adaptation en mailles entre la première couche de confinement 2 et le substrat 1.

Une composition préférée des couches de confinement 2 et 4, notamment dans le cas d'utilisation d'un substrat en GaAs est la suivante :

$$Ga_{0,49} In_{0,51} P.$$

Dans une telle structure, l'utilisation du $Ga_{0,49}In_{0,51}P$ à la place du GaA1As pour les couches de confinement permet d'éliminer les problèmes liés à la présence de l'aluminium. Ceux-ci sont de plusieurs ordres :

1) L'oxydation de la couche de GaA1As provoque l'apparition de centres de recombinaison non radiatifs. Ceci compromet la durée de vie du laser à cause de l'échauffement excessif du composant.

2) L'oxydation des miroirs de la cavité laser lors de l'échauffement du composant en fonctionnement continu provoque une dégradation rapide du laser au cours de son fonctionnement.

3) La température de croissance du GaA1As est élevée (de l'ordre de 700°C) et peu favorable à l'élaboration de matériaux GaInAs de bonne qualité.

Le $Ga_{0,49}In_{0,51}P$ présente les avantages suivants :

1) L'alliage $Ga_{0,49}In_{0,51}$ ne s'oxyde pas.

2) La température de croissance de l'alliage $Ga_{0,49} In_{0,51}P$ est basse (comprise entre 500 et 550°C). Cette température permet d'obtenir des alliages GaInAs présentant des propriétés optiques, électriques et structurales optimales.

L'utilisation d'une couche active à base de puits quantiques de GaInAs/GaAs permet d'autre part de bénéficier des avantages suivants :

1) Les substrats de GaAs, d'InP et de Si présentent d'excellentes propriétés structurales.

2) L'épaisseur de la couche 31 de GaInAs pseudomorphiques doit rester constamment inférieure à l'épaisseur critique, ce qui évite l'apparition de dislocations de désadaptation et permet d'obtenir des matériaux sans défauts.

3) A cause des effets de confinement à l'intérieur des puits quantiques de GaInAs, il suffit de modifier l'épaisseur des puits quantiques de GaInAs présents dans la couche active pour modifier la longueur d'onde d'émission du laser sans qu'il soit nécessaire de modifier la composition stoechiométrique de l'alliage GaInAs.

4) La présence de la contrainte dans la couche active a pour effet de lever la dégénérescence des bandes trous légers-trous lourds en diminuant la masse effective des trous lourds. Il s'ensuit une baisse de la densité de courant de seuil et une augmentation de l'insensibilité à la température des lasers.

5) Il est possible de réaliser l'intégration monolithique de ces lasers avec d'autres fonctions électroniques basées sur le même substrat.

Pour la réalisation d'un tel laser, on peut utiliser des substrats tels que Si, GaAs ou InP.

En utilisant la technique de croissance MOCVD ou MOMBE on réalise une série de superréseaux (couches d'adaptation) si cela est nécessaire selon le substrat utilisé.

Les couches suivantes sont ensuite réalisées en utilisant les mêmes techniques de croissance ;

– une couche de GaInP dopée au silicium, au soufre ou au tellure d'épaisseur égale à 2 $\mu$m par exemple, constituant la couche 2 de confinement de type n ;

– une couche 3 de matériaux GaAs-Ga$_x$In$_{1-x}$As-GaAs d'épaisseur égale à 200 nm, destinée à former la couche active du laser et comportant au moins un puits quantique en Ga$_x$In $_{1-x}$As réalisé dans la couche 3 ; -

– une couche de GaInP dopée zinc (type p) d'épaisseur sensiblement 100 nm. Cette couche de GaInP n'est pas réellement représentée sur la figure 1 ; elle est en fait confondue avec la couche 4 qui va maintenant être déposée et participe à l'effet de confinement.

Ensuite, on grave, par exemple en utilisant les techniques de photolithographie, des rubans avec une largeur de l'ordre de 1 $\mu$m avec un espacement de 300 $\mu$m dans la couche active 3. La couche de GaInP qui vient d'être déposée, protège la couche active 3 contre les effets de la gravure.

En utilisant la technique de croissance MOCVD ou MOMBE, on réalise ensuite la croissance de la couche GaInP dopée au zinc (type p) de 2 $\mu$m d'épaisseur, destinée à constituer la couche de confinement de type p et le contact ohmique.

En utilisant la technique de croissance MOCVD ou MOMBE, on réalise enfin une couche de contact pour la réalisation des contacts ohmiques.

Après la métallisation du laser, on fait une implantation de protons pour augmenter l'efficacité du confinement du courant électrique.

Selon l'invention, il est possible d'obtenir des lasers émettant à des longueurs d'ondes différentes en choisissant de façon appropriée la composition de la couche 31 du puits quantique et son épaisseur Z.

On rappelle que la formule de la couche constituant le puits quantique est :

$$Ga_xIn_{1-x}As$$

A titre d'exemple pratique de réalisation, dans des conditions de croissance de la couche de puits quantique 31 suivantes :

– température = 510°C

– pression = 100 mbar

– avec une couche 31 de Ga$_x$In$_{1-x}$As de composition telle que x = 0,825

On peut utiliser des lasers dont l'épaisseur Z de la couche 31 de Ga In As possède une valeur comprise entre 5 et 9 nm. Notamment, pour des valeurs de Z suivantes on obtient des lasers émettant aux longueurs d'ondes indiquées ci-dessous :

$$Z = 6 \text{ nm} \quad ; \quad \lambda \quad = 0,85 \ \mu m$$

$$Z = 6,5 \text{ nm} \quad ; \quad \lambda \quad = 0,98 \ \mu m$$

$$Z = 7 \text{ nm} \quad ; \quad \lambda \quad = 1,054 \ \mu m$$

$$Z = 7,5 \text{nm} \quad ; \quad \lambda \quad = 1,083 \ \mu m$$

$$Z = 9 \text{ nm} \quad ; \quad \lambda \quad = 1,2 \ \mu m$$

Dans des conditions de température et de pression de croissance identiques si on réalise des lasers dont l'épaisseur Z de la couche 31 de GaInAs a pour valeur 6,5 nm, il faut fixer la composition x en gallium comme indiqué ci-dessous pour émettre aux longueurs d'ondes indiquées en regard des valeurs de x :

$$x = 0,11 \quad ; \quad \lambda \quad = 2,5 \ \mu m$$

$$x = 0,75 \quad ; \quad \lambda \quad = 1,2 \ \mu m$$

$$x = 0,805 \quad ; \quad \lambda \quad = 1,08 \ \mu m$$

$$x = 0,815 \quad ; \quad \lambda \quad = 1,05 \ \mu m$$

$$x = 0,825 \quad ; \quad \lambda \quad = 0,98 \ \mu m$$

$$x = 0,99 \quad ; \quad \lambda \quad = 0,85 \ \mu m$$

Pour obtenir un laser émettant à une autre longueur d'onde on peut donc changer les valeurs de x et de Z. Par exemple avec Z = 9 nm et x = 0,15 environ on obtiendra un laser émettant à 2,5 $\mu$m.

On voit donc que l'on peut choisir x entre 0,11 et 0,99 et l'épaisseur Z entre 9 nm et 5 nm.

Les valeurs de Z et de x ont été données pour des conditions de réalisation (températures et pression) déterminées. Avec des conditions de réalisations différentes, pour obtenir un fonctionnement normal du laser à une longueur telle que par exemple l'une de celles indiquées précédemment, il convient de modifier la valeur de Z et/ou de x à partir des valeurs de Z et x indiquées ci-dessus pour cette longueur d'onde.

Plusieurs types de structures peuvent être prévues pour la réalisation de la couche active 3 du laser.

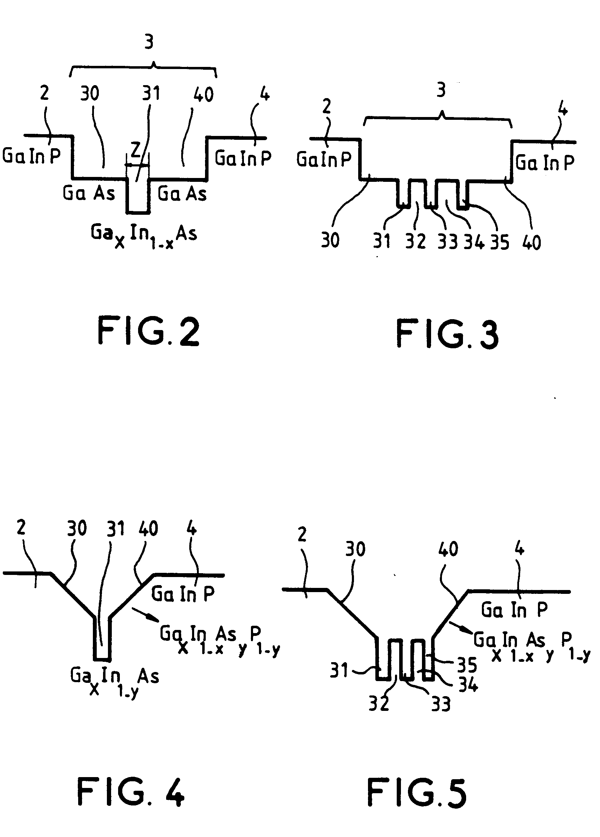

Selon la figure 2, on prévoit un seul puits quantique. L'épaisseur de la couche 31 est inférieure à 10 nm. L'épaisseur totale de la partie active (couches 30, 31, 40) est sensiblement comprise entre 80 et 100 nm.

Selon la figure 3, on prévoit un empilement de puits quantiques 31, 33, 35 séparés par des couches barrières 32, 34. Les épaisseurs des couches 31, 33, 35 sont celles indiquées précédemment selon le type de laser à obtenir. Les épaisseurs des couches barrières 32, 34 sont environ de 10 nm. Cette structure est du type SCH ( Separated Confinement Heterostructure ) à confinement séparé.

Une telle structure SCH présente une cavité optique en GaAs, avec des transitions d'énergie de gap abruptes de part et d'autre de la cavité. On produit ainsi une transition brutale de l'indice optique aux extrémités de la cavité.

L'invention peut également être réalisée en structure GRINSCH (Grated Index Separated Confinement Heterostructure) c'est-à-dire hétérostructure à confinement séparé à composition variable. Dans une telle structure, telle que représentée figure 4, les couches 30 et 40 qui encadrent la couche de puits quantique 31 sont en matériau du type :

$$Ga_xIn_{1-x}As_yP_{1-y}$$

La composition en As et en P (c'est-à-dire la valeur de y) varie graduellement entre la couche de puits quantique 31 et les couches de confinement 2 et 4 de telle façon que y a pour valeur 1 au voisinage de la couche 31 et a pour valeur 0 au voisinage des couches 2 et 4.

La structure de la figure 5 possède plusieurs puits quantiques 31, 33, 35 comme le dispositif de la figure 3, mais possède des couches 30 et 40 similaires à celles de la figure 5.

Une structure GRINSCH présente donc une cavité optique en $Ga_xIn_{1-x}As_yP_{1-y}$ dont la composition stœchiométrique varie graduellement depuis $Ga_{0,49}In_{0,51}P$ jusqu'au GaAs de manière à produire une variation graduelle et linéaire de l'énergie de gap de part et d'autre de la cavité optique. On produit ainsi une transition d'indice optique graduelle de part et d'autre de la cavité.

Le confinement est meilleur dans les structures SCH que dans les structures GRINSCH. En revanche, les recombinaisons dans la cavité sont moins importantes dans le cas du GRINSCH, ce qui assure à cette structure des performances potentielles supérieures à celles de la structure SCH.

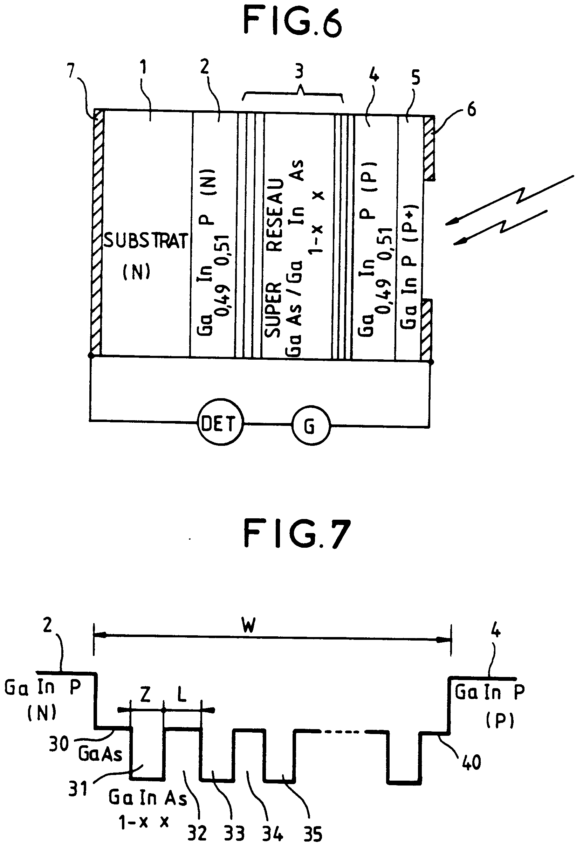

En se reportant aux figures 6 et 7, on va maintenant décrire un exemple de réalisation d'un photodétecteur selon l'invention. Ce dispositif comporte, sur un substrat 1, une première couche de confinement réalisée en un matériau à base de GaInP présentant un paramètre de maille adapté à celui du substrat 1. Sur cette couche de confinement est réalisé un empilement de couches 30, 32, 34 .... 40 en GaAs alternées avec des couches 31, 33, 35 de $Ga_{1-x}In_xAs$. Un tel empilement de couches constitue un super-réseau possédant un diagramme d'énergie de la bande de conduction représentée en figure 7.

Le super-réseau 3 est recouvert d'une deuxième couche de confinement 4 à base de GaInP.

La partie supérieure de la structure possède une couche de contact 5 et un contact ohmique 7. Une ouverture 9 prévue dans le contact 7 permet de laisser passer la lumière à détecter.

Un autre contact ohmique 6 est prévu sur le côté opposé de la structure de façon à connecter une source de courant de commande du laser. Selon l'exemple de la figure 1, le contact ohmique 6 est situé sur une face de substrat, le substrat étant alors en matériau conducteur. On pourrait également prévoir, entre la couche de confinement et le substrat, une couche de semiconducteur dopé servant de couche de contact sur laquelle serait prévu un contact ohmique.

A titre d'exemple, le substrat 1 de la figure 1 est en GaAs dopé N. La première couche de confinement 2 en GaInP est dopé N. La deuxième couche de confinement 3 en GaInP est dopé P. La couche de contact 5 est en GaAs dopé P+.

Les contacts ohmiques sont en or.

Le substrat 1 pourrait également être en InP ou en silicium, on prévoirait alors une couche ou un réseau d'adaptation en mailles entre la première couche de confinement 2 et le substrat 1.

Une composition préférée des couches de confinement 2 et 4, notamment dans le cas d'utilisation d'un substrat en GaAs est :

$$Ga_{0,49}In_{0,51}As$$

L'originalité de l'invention consiste donc à utiliser pour cette application les matériaux

$$Ga_{0,49}In_{0,51}P/Ga_{1-x}In_xAs/GaAs$$

en ajustant la valeur de x entre 0.5 et 0.95 de manière à obtenir un matériau de gap égal correspondant à la longueur à détecter.

1) On peut utiliser des substrats tels que Si, GaAs, InP ou d'autres matériaux III-V ou II-VI, SiC, Ge ...

2) En utilisant la technique de croissance MOCVD ou MOMBE, on réalise une série de superréseaux (couches d'adaptation).

3) Les couches suivantes sont ensuite réalisées pour l'élaboration de la structure p-i-n du photodétecteur en mettant en oeuvre les mêmes techniques de croissances :

– une couche de confinement de $Ga_{0,49}In_{0,51}P$ dopée de type n (Si ou S ou Se) de 0.5 à 1 $\mu$m d'épaisseur
– la couche active non intentionnellement dopée constituée par exemple de 100 périodes de superréseau GaAs-$Ga_{1-x}In_xAs$ avec des barrières de GaAs de 5 nm à 10 nm d'épaisseur et des puits de $Ga_{1-x}In_xAs$ d'épaisseur inférieures à 10 nm. L'épaisseur totale de la couche active est dans ce cas comprise entre 1.5 et 2 $\mu$m
– une couche de $Ga_{0,49}In_{0,51}P$ dopée de type p au zinc de 0,5 $\mu$m d'épaisseur et comportant une fenêtre 9.

L'utilisation d'une couche active à base de superréseau GaAs-$Ga_{1-x}In_xAs$ permet de bénéficier des avantages suivants :

1) L'épaisseur des couches de GaInAs pseudomorphique reste constamment inférieure à l'épaisseur critique, ce qui évite l'apparition des dislocations de désadaptation et permet d'obtenir des couches sans défauts.

2) La contrainte présente dans la couche active a pour effet de lever la dégénérescence des bandes trous légers-trous lourds dans cette région, en diminuant la masse effective des trous lourds ce qui augmente leur mobilité.

Ceci est favorable pour les applications dans le domaine des hyperfréquences, en augmentant la rapidité de réponse du photodétecteur.

3) On peut modifier aisément la longueur d'onde de détection du photodétecteur en modifiant l'épaisseur des puits quantiques de GaInAs, sans avoir besoin de recourir à un changement de composition stoechiométrique de l'alliage $Ga_{1-x}In_xAs$.

4) La structure proposée est beaucoup plus simple à réaliser que les structures de photodétecteurs à base d'antimoniures pour les raisons suivantes :

– meilleure qualité des substrats
– plus grande pureté de matériaux
– facilité d'intégration monolithique avec des transistors à base de GaAs.

A titre d'exemple de réalisation, pour détecter un rayonnement d'une longueur d'onde de 2,5 $\mu$m, les caractéristiques du super réseau 3 sont les suivantes :

– épaisseur Z de chaque couche de puits quantique = 5 à 9 nm
– épaisseur L de chaque couche barrière = 5 à 10 nm
– épaisseur totale W du super réseau = 1,5 à 2 $\mu$m
– valeur du coefficient de composition x en indium = 0,5 à 0,95

La description qui précède n'a été faite qu'à titre d'exemple. D'autres variantes peuvent être envisagées sans sortir du cadre de l'invention.

Les valeurs numériques et de matériaux n'ont été fournis que pour illustrer la description.

Notamment les valeurs de x et de l'épaisseur Z des dispositifs ont été données pour des conditions de réalisation (température et pression) déterminées. Dans d'autres conditions de réalisation il conviendrait d'ajuster les valeurs de x et de Z en les faisant varier, par exemple, par rapport aux valeurs indiquées ci-dessus.

## Revendications

1. Dispositif optoélectronique caractérisé en ce qu'il comporte une couche active contenant au moins un puits quantique constitué d'une couche (31) à base de GaInAs comprise entre deux couches barrières (30, 32, 34 . . . 40) à base de GaAs, cette couche active étant comprise entre une première et une deuxième couche de confinement (2, 4) à base de GaInP.

2. Laser à puits quantiques selon la revendication 1, caractérisé en ce qu'il comporte une couche active (3) contenant au moins un puits quantique constitué d'une couche (31) à base de $Ga_xIn_{1-x}$ comprise entre deux couches (30, 32, 34 ...40) de GaAs, cette couche active étant comprise entre une première et une deuxième couches de confinement (2, 4) à base de GaInP.

3. Laser selon la revendication 1, caractérisé en ce que l'ensemble du laser est réalisé sur un substrat (1), la composition de la première couche de confinement, qui est en contact avec le substrat étant telle que son paramètre de maille est adapté, soit directement, soit par une couche ou un réseau d'adaptation, à celui du substrat.

4. Laser selon la revendication 2, caractérisé en ce que la première couche de confinement (2) est dopée d'un premier type (N) et la deuxième couche de confinement est dopée d'un deuxième type (P) et que le substrat est dopé du premier type (N).

5. Laser selon la revendication 4, caractérisé en ce que le substrat comporte une couche de contact ohmique et que la deuxième couche de confinement (4) comporte une couche de contact (5) fortement dopée du même type (p+) que la deuxième couche de confinement (4), cette couche de contact (5) supportant un contact ohmique (7).

6. Laser selon la revendication 2, caractérisé en ce que la couche de $Ga_xIn_{1-x}As$ a une composition telle que x est compris entre 0,11 et 0,99 et que son épaisseur (Z) est comprise entre 9 nm et 5 nm.

7. Laser selon la revendication 2, caractérisé en ce que les couches barrières (30, 40) en contact avec les couches de confinement (2, 4) comportent également de l'indium et du phosphore pour présenter une composition de formule :

$$Ga_xIn_{1-x}As_yP_{1-y}$$

la valeur de y variant entre 0 et 1 de telle façon que la composition de ces couches de confinement varie entre la composition GaInP pour la partie de ces couches en contact avec les couches de confinement (2, 4) et la composition $Ga_xI_{1-x}As$ pour la partie de ces couches en contact avec la couche (31) de puits quantique.

8. Laser selon la revendication 2, caractérisé en ce que la couche active se présente sous la forme d'un ruban 3 situé sur la première couche de confinement (2), la deuxième couche de confinement (4) recouvrant le ruban 3 et la première couche de confinement (2) située de part et d'autre du ruban (2) de façon à constituer une structure enterrée.

9. Photodétecteur selon la revendication 1, caractérisé en ce qu'il comporte au moins un puits quantique constitué d'une couche (31) à base de $Ga_{1-x}In_xAs$ comprise entre deux couches barrière (30, 32, 34, ...40) à base de GaAs, l'ensemble étant compris entre une première et une deuxième couches de confinement (2, 4) à base de GaInP.

10. Photodétecteur selon la revendication 9, caractérisé en ce que l'ensemble du photodétecteur est réalisé sur un substrat (1), la composition de la première couche de confinement, qui est en contact avec le substrat, étant telle que son paramètre de maille est adapté, soit directement, par une couche ou un réseau d'adaptation, au paramètre de maille du substrat.

11. Photodétecteur selon la revendication 9, caractérisé en ce que l'ensemble du laser est réalisé sur un substrat (1) en GaAs ou en silicium, ou semiconducteur III-V ou II-VI ou IV..

12. Photodétecteur selon la revendication 9, caractérisé en ce que la première couche de confinement (2) est dopée d'un premier type (N) et la deuxième couche de confinement est dopée d'un deuxième type (P) et que le substrat est dopé du premier type (N).

13. Photodétecteur selon la revendication 12, caractérisé en ce que le substrat comporte une couche de contact ohmique et que la deuxième couche de confinement (4) comporte une couche de contact (5) fortement dopée du même type (P+) que la deuxième couche de confinement (4), cette couche de contact (5) supportant un contact ohmique (7).

14. Photodétecteur selon la revendication 9, caractérisé en ce que la couche de $Ga_{1-x}In_xAs$ a une composition telle que x est compris entre 0,5 et 0,95 et qu son épaisseur (Z) est compris entre 5 et 9 nm.

15. Photodétecteur selon la revendication 9, caractérisé en ce que les couches barrières (30, 40) en contact avec les couches de confinement (2, 4) comportent également de l'indium et du phosphore pour présenter une composition de formule :

$$Ga_x In_{1-x} As_y P_{1-y}$$

la valeur de y variant entre 0 et 1 de telle façon que la composition de ces couches de confinement varie entre la composition GaInP pour la partie de ces couches en contact avec les couches de confinement (2, 4) et la composition $Ga_x I_{1-x}As$ pour la partie de ces couches en contact avec la couche (31) de puits quantique.

16. Photodétecteur selon la revendication 14, caractérfisé en ce qu'il comporte plusieurs puits quantiques (30, 31, 32, 34, 40 .... ), l'épaisseur des couches barrières des puits quantiques étant comprise entre 5 et 10 nm.

7
5
4
8
3
2
1
6

Ga As
(N) substrat

N contact (Au)

# FIG. 1

FIG.2

FIG.3

FIG. 4

FIG.5

# FIG.6

# FIG.7

**Office européen des brevets**

# RAPPORT DE RECHERCHE EUROPEENNE

Numéro de la demande

EP 91 40 2304

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|---|---|---|---|
| A | APPLIED PHYSICS LETTERS. vol. 56, no. 23, 4 Juin 1990, NEW YORK, US pages 2293 - 2294; N.K. DUTTA ET AL.: 'Linewidth enhancement factor in strained quantum well lasers' * le document en entier * --- | 1,2,6 | H01L31/0352 H01L33/00 H01S3/19 |
| A | APPLIED PHYSICS LETTERS. vol. 53, no. 1, 4 Juillet 1988, NEW YORK, US pages 1 - 3; M. KITIMURA ET AL.: 'High-power operation in InGaAs separate confinement heterostructure quantum well laser diodes' * le document en entier * --- | 1,2,6,7 | |
| A | APPLIED PHYSICS LETTERS. vol. 47, no. 7, Octobre 1985, NEW YORK, US pages 733 - 735; G.E. BULMAN ET AL.: 'Photocurrent multiplication in ion implanted lateral In0.2Ga0.8As/GaAs strained-layer superlattice photodetectors' * le document en entier * --- | 1,9,11 | |
| A | IEEE PHOTONICS TECHNOLOGY LETTERS vol. 1, no. 11, Novembre 1989, NEW YORK, US pages 376 - 378; F.S. CHOA ET AL.: 'Optoelectronic properties of InGaAs/InGaAsP multiple-quantum-well waveguide detectors' * le document en entier * --- | 1,9,15 | DOMAINES TECHNIQUES RECHERCHES (Int. Cl.5 ) H01L H01S |
| X,P | EP-A-0 426 419 (THE FURAKAWA ELECTRIC CO. LTD.) * revendication 4 * ----- | 1,2 | |

Le présent rapport a été établi pour toutes les revendications

| Lieu de la recherche | Date d'achèvement de la recherche | Examinateur |
|---|---|---|
| LA HAYE | 27 JANVIER 1992 | LINA F. |